# EUROPEAN PATENT APPLICATION

(11) **EP 1 304 617 A2**
(43) Date of publication of application: **23.04.2003**
(21) Application number: 02013938.2
(22) Date of filing: 24.06.2002
(51) Int. Cl.: G06F 11/36

(54) **Optical navigation sensor with shadow memory**

(30) Priority: 22.10.2001 US 53993
(71) Applicant: Agilent Technologies Inc. (a Delaware Corporation), Palo Alto, CA 94306-2024 (US)
(72) Inventor: Wei, Patrick, Malvern, Pennsylvania 19355 (US); Norskog, Allen C., Fort Collins, Colorado 80525 (US)
(74) Representative: Schoppe, Fritz, Dipl.-Ing.

(57) **Abstract**

A semiconductor device and method for modifying the firmware of the device after fabrication utilizes a shadow memory (112) to "shadow" some or all of the original firmware in the ROM (110). In an exemplary embodiment, the semiconductor device is an optical navigation sensor that generates tracking information using captured surface images and a navigation code, which is included in the firmware. The shadow memory may be programmed with a complete modified firmware, which replaces the original firmware, or modified portions of the original firmware, which replace the corresponding portions of the original firmware. The use of the shadow memory allows the original firmware of the semiconductor device to be updated after the fabrication of the device. In addition, the shadow memory allows other data such as product identification information and proprietary functionality codes to be incorporated into the semiconductor device after fabrication.

## Description

### FIELD OF THE INVENTION

The invention relates generally to semiconductor devices, and more particularly to an optical navigation sensor.

### BACKGROUND OF THE INVENTION

Optical navigation sensors have been developed that can be used in a handheld device, such as a computer mouse or a handheld scanner, to optically track the movements of the device. Unlike mechanical tracking systems, optical navigation sensors do not include any mechanical components. Instead, an optical navigation sensor utilizes a solid-state imaging sensor that optically acquires sequential surface images. These sequential surface images are then mathematically analyzed to measure changes in position of the handheld device by determining the direction and magnitude of the movement. The output of an optical navigation sensor may be a stream of Δx and Δy relative displacement values, which provides navigation information to track the movement of the handheld device. Since optical navigation sensors do not depend on mechanical components, these sensors tend to be more accurate and reliable than the mechanical tracking systems.

A conventional optical navigation sensor includes a solid-state imaging sensor, a read-only memory (ROM) and a processor. The solid-state imaging sensor may be a charged coupled device (CCD) sensor, a complementary metal oxide semiconductor (CMOS) imaging sensor, or other photosensitive imaging sensor. The solid-state imaging sensor is used to sequentially capture images of the surface on which the handheld device is manipulated. These sequential surface images are then processed by the processor of the optical navigation sensor using a navigation code to output a stream of Δx and Δy relative displacement values. The navigation code is stored in the ROM of the optical navigation sensor as firmware, which is programmed into the ROM during fabrication of the optical navigation sensor. The use of ROM to store the navigation code provides an economic solution with respect to chip area and power consumption.

A concern with the conventional optical navigation sensor is that, after the optical navigation sensor is fabricated, the firmware of the sensor cannot be changed without replacing the ROM. Consequently, if the navigation code is updated or modified due to, for example, software bugs, a new optical navigation sensor needs to be fabricated to integrate the debugged navigation code into the sensor. Such limitations can delay product release schedules and increase the cost to manufacture the handheld devices with the optical navigation sensors when the original navigation code needs to be modified for any reason.

In view of this concern, there is a need for an optical navigation sensor and method for modifying the firmware of the sensor after fabrication.

### SUMMARY OF THE INVENTION

A semiconductor device and method for modifying the firmware of the device after fabrication utilizes a shadow memory to "shadow" some or all of the original firmware in the ROM. In an exemplary embodiment, the semiconductor device is an optical navigation sensor that generates tracking information using captured surface images and a navigation code, which is included in the firmware. The shadow memory may be programmed with a complete modified firmware, which replaces the original firmware, or modified portions of the original firmware, which replace the corresponding portions of the original firmware. The use of the shadow memory allows the original firmware of the semiconductor device to be updated after the fabrication of the device. In addition, the shadow memory allows other data such as product identification information and proprietary functionality codes to be incorporated into the semiconductor device after fabrication.

A semiconductor device in accordance with the present invention includes a non-reprogrammable memory that includes original codes, a reprogrammable shadow memory that can be programmed with modified codes, a processor that processes input data according to accessed codes that include at least some of the modified codes in the reprogrammable shadow memory, and a shadow memory controller that operatively connects the processor to the non-reprogrammable memory and the reprogrammable shadow memory. The shadow memory controller is configured to selectively provide the accessed codes from the non-reprogrammable memory and the reprogrammable shadow memory to the processor in response to requests from the processor.

In an embodiment, the semiconductor device further includes a solid-state imaging sensor that electronically captures images, which are processed by the processor to generate tracking information of the semiconductor device.

In an embodiment, the processor is configured to decrypt the modified codes when the modified codes are loaded into the semiconductor device to be programmed into the reprogrammable shadow memory. In this embodiment, the modified codes are in an encrypted format when loaded into the semiconductor device.

In some embodiments, the reprogrammable shadow memory has a storage capacity that equals or exceeds the storage capacity of the non-reprogrammable memory. In these embodiments, the shadow memory controller is configured to exclusively provide the modified codes from the reprogrammable shadow memory to the processor during operation.

In other embodiments, the reprogrammable shadow memory has a storage capacity that is less than the storage capacity of the non-reprogrammable memory. In these embodiments, the shadow memory controller is configured to selectively provide the modified codes from the reprogrammable shadow memory and the original codes from the non-reprogrammable memory to the processor during operation.

In an embodiment, the reprogrammable shadow memory can be programmed with additional data after the fabrication of the semiconductor device. The additional data may include product identification information and/or proprietary functionality codes.

A method of modifying original codes in a non-reprogrammable memory of a semiconductor device in accordance with the invention includes the steps of programming modified codes of the original codes into a reprogrammable shadow memory of the semiconductor device after the fabrication of the semiconductor device, accessing the modified codes in the reprogrammable shadow memory, and processing input data using at least the modified codes in the reprogrammable shadow memory.

In an embodiment, the method further includes the step of capturing images using a solid-state imaging sensor of the semiconductor device to produce the input data. In this embodiment, the step of processing the input data includes generating tracking information of the semiconductor device.

In an embodiment, the method further includes the steps of loading an encrypted data of the modified codes into the semiconductor device, and decrypting the encrypted data of the modified codes, prior to the step of programming the modified codes into the reprogrammable shadow memory of the semiconductor device.

In some embodiments, the step of accessing the modified codes in the reprogrammable shadow memory includes exclusively retrieving the modified codes of the reprogrammable shadow memory to process the input data.

In other embodiments, the step of accessing the modified codes in the reprogrammable shadow memory includes selectively retrieving the modified codes of the reprogrammable shadow memory and the original codes of the non-reprogrammable memory to process the input data.

In an embodiment, the method further includes the step of programming additional data into the reprogrammable shadow memory of the semiconductor device. The additional data may include product identification information and/or proprietary functionality codes.

Other aspects and advantages of the present invention will become apparent from the following detailed description, taken in conjunction with the accompanying drawings, illustrated by way of example of the principles of the invention.

### BRIEF DESCRIPTION OF THE DRAWINGS

Fig. 1 is a block diagram of an optical navigation sensor in accordance with the present invention.

Fig. 2 illustrates the shadow memory controller of the optical navigation sensor that connects the processor to the ROM and the shadow memory.

Fig. 3 is a block diagram of the shadow memory controller of the optical navigation sensor.

Fig. 4 is a process flow diagram of a method for modifying the firmware of the optical navigation sensor in accordance with the present invention.

### DETAILED DESCRIPTION

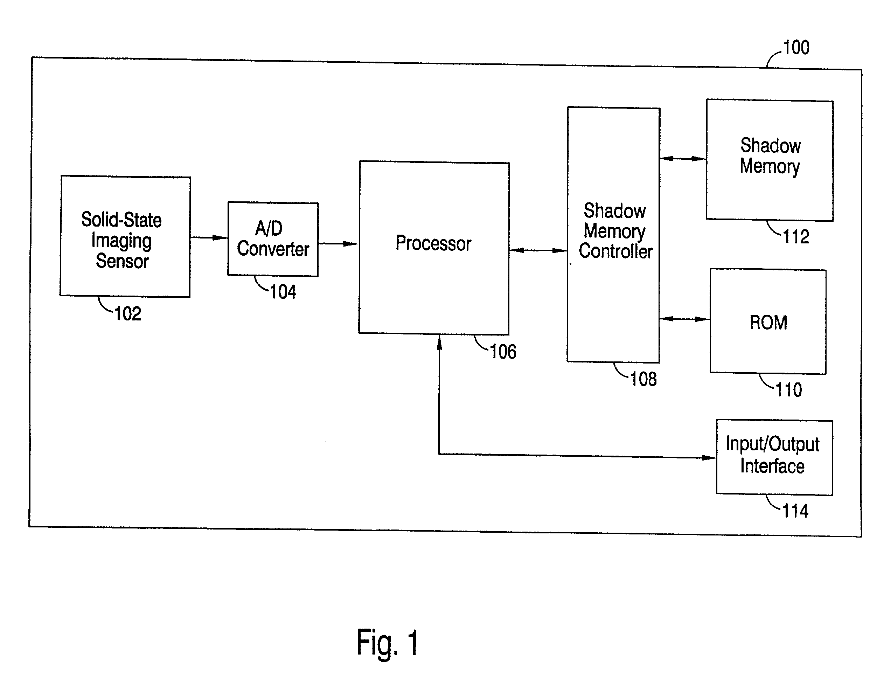

With reference to Fig. 1, an optical navigation sensor 100 in accordance with the invention is shown. The optical navigation sensor operates to provide tracking information of the sensor with respect to a reference surface. Thus, the optical navigation sensor can be used in a handheld device that requires tracking information, such as a computer mouse or a handheld scanner. The tracking information is generated by the optical navigation sensor by sequentially capturing images of the reference surface to detect the movements of the sensor in relation to the reference surface. These sequential surface images are then mathematically processed using a navigation code, which is embedded in the sensor as firmware, to generate the tracking information. In contrast to conventional optical navigation sensors, the optical navigation sensor 100 is designed such that the navigation code can be easily debugged or modified after the fabrication of the sensor. Furthermore, the optical navigation sensor allows post-fabrication programming of proprietary codes and information.

The optical navigation sensor 100 includes a solid-state imaging sensor 102, an analog-to-digital (A/D) converter 104, a processor 106, a shadow memory controller 108, a read-only memory (ROM) 110, a shadow memory 112, and an input/output interface 114. Other components that are commonly found in conventional optical navigation sensors are not described herein as not to unnecessarily obscure aspects of the invention. In an exemplary embodiment, the optical navigation sensor is an application specific integrated chip (ASIC). Thus, in the exemplary embodiment, the components of the optical navigation sensor are on a single semiconductor chip.

The solid-state imaging sensor 102 of the optical navigation sensor 100 operates to electronically capture images of a reference surface. The solid-state imaging sensor may be a charged coupled device (CCD) sensor, a complementary metal oxide semiconductor (CMOS) imaging sensor, or other photosensitive imaging sensor. As an example, the solid-state imaging sensor may be a 16-by-16 pixel imaging sensor. However, the solid-state imaging sensor may be larger or smaller. The solid-state imaging sensor captures images as analog image signals. Thus, the output of the solid-state imaging sensor is a series of analog image signals, which are converted into digital image signals by the A/D converter 104 of the optical navigation sensor.

The ROM 110 of the optical navigation sensor 100 contains the original firmware, including the original navigation code. The original firmware is programmed into the ROM during fabrication of the optical navigation sensor. Thus, the ROM cannot be reprogrammed to modify the original firmware in the ROM after the fabrication of the optical navigation sensor. The ROM can be any type of read-only memory.

The shadow memory 112 of the optical navigation sensor 100 is a reprogrammable memory. The shadow memory can be any type of a read/write memory, such as a read/write random access memory (RAM). In a first embodiment of the invention, the shadow memory has at least the same storage capacity as the ROM 110. In this first embodiment, the shadow memory is used to store a complete modified version of the original firmware contained in the ROM. Thus, when the shadow memory is programmed with a modified firmware, the entire original firmware in the ROM can be "shadowed" by the modified firmware in the shadow memory. That is, the original firmware in the ROM is completely replaced by the modified firmware in the shadow memory.

The use of the shadow memory 112 allows the original firmware of the optical navigation sensor 100 in the ROM 110 to be "reprogrammed" when "bugs" are found in the original firmware by programming a modified firmware into the shadow memory, which can then replace the original firmware in the ROM. In addition, updates to the original firmware can be programmed into the optical navigation sensor, allowing the manufacturers of devices with the optical navigation sensor to integrate the latest optical navigation technologies into the final shipping products. Furthermore, the use of the shadow memory allows each device manufacturer to differentiate its product from that of other manufacturers by allowing the device manufacturer to implement product identification information and proprietary functionalities into the optical navigation sensor.

In a second embodiment of the invention, the shadow memory 112 of the optical navigation sensor 100 has less storage capacity than the ROM 110. As an example, the shadow memory may have a storage capacity equal to quarter, half or three-quarters of the storage capacity of the ROM. The use of a smaller sized shadow memory decreases the overall cost to fabricate the optical navigation sensor. In addition, the size of the optical navigation sensor can be decreased as a result of the smaller sized shadow memory in accordance with the second embodiment.

In the second embodiment, due to the reduced storage capacity of the shadow memory 112, a complete modified firmware that can replace the original firmware in the ROM 110 cannot be programmed into the shadow memory. Thus, in this embodiment, only portions of the modified firmware are programmed into the smaller sized shadow memory. Portions of the modified firmware contained in the shadow memory are sometimes referred herein as the modified firmware. These firmware portions are used to shadow the corresponding portions of the original firmware contained in the ROM. Consequently, the original firmware contained in the ROM can be modified by essentially replacing selected portions of the original firmware with corresponding modified portions, which are programmed into the shadow memory. For example, if a portion of the navigation code in the original firmware was found to have a bug, then a corresponding debugged portion of the navigation code can be programmed into the smaller sized shadow memory. In this example, after the debugged portion of the navigation code is programmed into the shadow memory, the debugged portion in the shadow memory is used rather than the corresponding portion of the original navigation code, which effectively debugs the navigation code that was initially programmed into the ROM. Similar to the first embodiment, the smaller sized shadow memory can also be used to program additional information or codes, such as product identification information and proprietary functionality codes.

As described above, the shadow memory 112 in accordance with the first embodiment can be used to fully shadow the original firmware in the ROM 110, while the shadow memory in accordance with the second embodiment can be used to partly shadow the original firmware. However, the shadow memory in accordance with the first embodiment can also be used to partly shadow the original firmware in the ROM.

ROMs are typically slower than RAMs. Thus, a shadowing technique has been used in the past to increase the speed of a computer by using a high-speed RAM in place of a slower ROM. As an example, personal computers (PCs) may be configured to copy the BIOS code from a ROM to a RAM when the computer boots. Thus, the BIOS code in the ROM is duplicated in the RAM, where the copied BIOS code can be accessed more quickly than the original BIOS code in the ROM. In this conventional technique, the code in the RAM, or the shadow memory, is identical to the original code in the ROM, which is not the case in the present invention.

The processor 106 of the optical navigation sensor 100 operates to process the surface images captured by the solid-state imaging sensor 102 using the original firmware contained in the ROM 110 and/or the modified firmware contained in the shadow memory 112. The processor is connected to the A/D converter 104 to receive digital image signals of captured surface images. Further, the processor is connected to both the ROM and the shadow memory via the shadow memory controller 108 to selectively access the original firmware and/or the modified firmware. Using the navigation code in the original firmware and/or the modified firmware, the processor processes the digital image signals using mathematical calculations to output tracking information through the input/output interface 114. In the exemplary embodiment, the tracking information is generated as a stream of Δx and Δy relative displacement values. Mathematical calculations performed by the processor may include prediction, correlation and interpolation.

The shadow memory controller 108 of the optical navigation sensor 100 operates to selectively provide either the original firmware in the ROM 110 or the modified firmware in the shadow memory 112 to the processor 108. Thus, when the processor attempts to access the firmware, the shadow memory controller serves as an interface between the processor and both the ROM and the shadow memory to provide the appropriate data. In the first embodiment, the shadow memory controller functions either in a normal mode, during which only the original firmware in the ROM is provided, or in a shadow mode, during which only the modified firmware in the shadow memory is provided. In the second embodiment, the shadow memory controller selectively provides data from the original firmware in the ROM or from the modified firmware in the shadow memory, depending on the request or the address signal from the processor to access particular data.

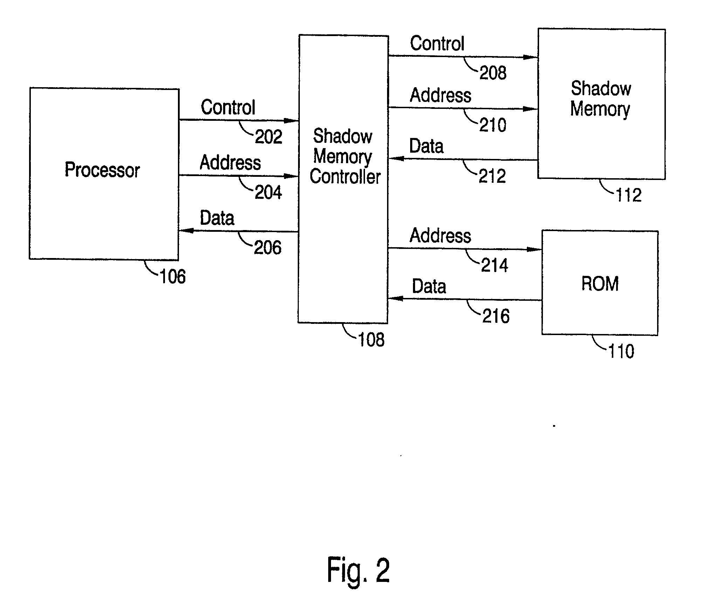

In the exemplary embodiment, the shadow memory controller 108 is connected to the processor 106 by a control bus 202, an address bus 204 and a data bus 206, as illustrated in Fig. 2. The control bus 202 is used to transmit control signals from the processor to write data into the shadow memory 112. The control signals may include address signals, data to be written and write select signals. The address bus 204 is used to transmit address signals from the processor to read data from the ROM 110 or the shadow memory. The data bus 206 is used to receive data from either the ROM or the shadow memory via the shadow memory controller, depending on the address signals. The shadow memory controller is similarly connected to the shadow memory by a shadow memory control bus 208, a shadow memory address bus 210 and a shadow memory data bus 212. The shadow memory control bus 208 is used to transmit the data to be written and the write select signals to the shadow memory. The shadow memory address and data buses 210 and 212 are used to transmit address signals to the shadow memory and to receive the corresponding data from the shadow memory. The shadow memory controller is also connected to the ROM by a ROM address bus 214 and a ROM data bus 216. The ROM address and data buses are used to transmit address signals to the ROM and to receive the corresponding data from the ROM.

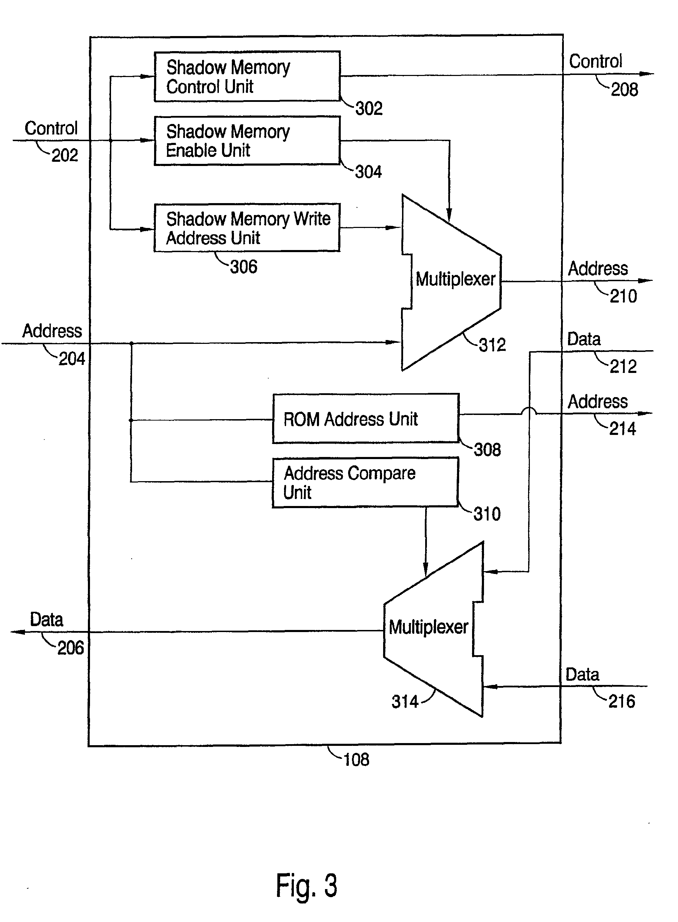

As illustrated in Fig. 3, the shadow memory controller 108 includes a shadow memory control unit 302, a shadow memory enable unit 304, a shadow memory write address unit 306, an optional ROM address unit 308, an address compare unit 310 and multiplexers 312 and 314. The components 302-306 and 312 of the shadow memory controller are used to write data into the shadow memory 112. The shadow memory enable unit 304 operates to enable the multiplexer 312 to transmit address signals to write data into the shadow memory. The shadow memory write address unit 306 operates to identify the location in the shadow memory into which data is to be written. When the location in the shadow memory is identified, the shadow memory write address unit transmits the appropriate address signal to the shadow memory through the multiplexer 312, which has been enabled to route signals from the shadow memory write address unit 306, instead of signals from the address bus 204. The shadow memory control unit 302 operates to selectively transmit the write select signal and the data to be written into the shadow memory in response to control signals from the processor 106, so that the data can be written into the shadow memory.

The components 308, 310 and 314 of the shadow memory controller 108 are used to selectively read data from the ROM 110 or the shadow memory 112. The optional ROM address unit 308 operates to send either a ROM address signal or a constant signal to the ROM in response to an address signal from the processor 106. The constant signal is used when only data from the shadow memory is being read, e.g., during the shadow mode. The ROM may be configured to not respond to the constant signal from the ROM address unit, and consequently, power consumption can be reduced by not reading out unwanted data from the ROM for every address signal from the processor. The address compare unit 310 operates to control the multiplexer 314 to allow either data from the shadow memory or the data from the ROM to be transmitted to the processor, depending on the initial address signal from the processor.

Turning back to Fig. 1, the input/output interface 114 of the optical navigation sensor 100 allows a modified firmware to be loaded into the sensor to program the modified firmware into the shadow memory 112 through the shadow memory controller 108. The input/output interface also allows the optical navigation sensor to output the tracking information, which is computed by the processor 106 using captured surface images. The input/output interface is a port to receive the modified firmware and to output the tracking information as electronic data. As an example, the input/output interface may be a serial port. In the exemplary embodiment, a modified firmware that is loaded into the optical navigation sensor is encrypted according to a known encryption scheme. The encrypted, modified firmware is decrypted by the processor 106 using a key, which may be hardwired in the processor. The decrypted firmware is then used to program the modified firmware into the shadow memory. Since the modified firmware is encrypted, the modified firmware can be securely distributed through widely used distribution channels, such as the Internet.

After the modified firmware is programmed into the shadow memory 112 through the input/output interface 114, the modified firmware can be replaced with a new firmware by deleting the modified firmware and programming the new firmware. Thus, the firmware in the shadow memory can be reprogrammed indefinitely.

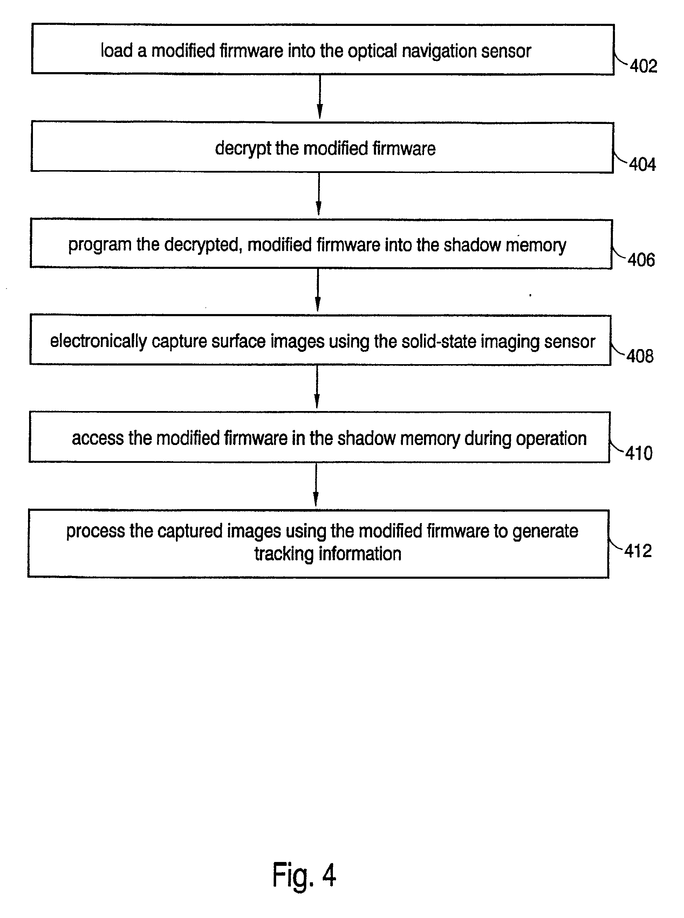

A method of modifying the original firmware in the ROM 110 of the optical navigation sensor 100 is described with reference to the flow diagram of Fig. 4. At step 402, a modified firmware is loaded into the optical navigation sensor. The modified firmware may be a complete modified firmware, or one or more modified portions of the original firmware. In the exemplary embodiment, the modified firmware is encrypted using a known encryption scheme. At optional step 404, if the modified firmware is encrypted, the modified code is decrypted using a key. Next, at step 406, the decrypted, modified firmware is programmed into the shadow memory 112 of the optical navigation sensor through the shadow memory controller 108. At step 408, surface images are electronically captured by the solid-state imaging sensor 102 of the optical navigation sensor. At step 410, the modified firmware in the shadow memory is accessed by the processor 106 through the shadow memory controller during operation of the optical navigation sensor. At step 412, the captured images are processed using to the modified firmware to generate tracking information of the optical navigation sensor.

Although specific embodiments of the invention have been described and illustrated, the invention is not to be limited to the specific forms or arrangements of parts so described and illustrated. The scope of the invention is to be defined by the claims appended hereto and their equivalents.

## Claims

1. A semiconductor device comprising:
a non-reprogrammable memory (110) that includes original codes;
a reprogrammable shadow memory (112) that can be programmed with modified codes;
a processor (106) that processes input data according to accessed codes, the accessed codes including at least some of the modified codes in the reprogrammable shadow memory; and
a shadow memory controller (108) that operatively connects the processor to the non-reprogrammable memory and the reprogrammable shadow memory, the shadow memory controller being configured to selectively provide the accessed codes from the non-reprogrammable memory and the reprogrammable shadow memory to the processor in response to requests from the processor.

2. The semiconductor device of claim 1 further comprising a solid-state imaging sensor (102) that electronically captures images, which are processed by the processor (106) to generate tracking information of the semiconductor device.

3. The semiconductor device of claim 1 or 2 wherein the processor (106) is configured to decrypt the modified codes when the modified codes are loaded into the semiconductor device to be programmed into the reprogrammable shadow memory (112), the modified codes being in an encrypted format when loaded into the semiconductor device.

4. The semiconductor device of claim 1, 2 or 3 wherein the reprogrammable shadow memory (112) has a storage capacity that is less than the storage capacity of the non-reprogrammable memory (110).

5. The semiconductor device of claim 4 wherein the shadow memory controller (108) is configured to selectively provide the modified codes from the reprogrammable shadow memory (112) and the original codes from the non-reprogrammable memory (110) to the processor (106) during operation.

6. A method of modifying original codes in a non-reprogrammable memory (110) of a semiconductor device comprising:
programming (406) modified codes of the original codes into a reprogrammable shadow memory (112) of the semiconductor device after the fabrication of the semiconductor device;
accessing (410) the modified codes in the reprogrammable shadow memory; and
processing (412) input data using at least the modified codes in the reprogrammable shadow memory.

7. The method of claim 6 further comprising capturing images using a solid-state imaging sensor (102) of the semiconductor device to produce the input data, and wherein the processing (412) of the input data includes generating tracking information of the semiconductor device.

8. The method of claim 6 or 7 further comprising:
loading (402) an encrypted data of the modified codes into the semiconductor device; and
decrypting (404) the encrypted data of the modified codes, prior to the programming (406) of the modified codes into the reprogrammable shadow memory (112) of the semiconductor device.

9. The method of claim 6, 7 or 8 wherein the accessing (410) of the modified codes in the reprogrammable shadow memory (112) includes selectively retrieving the modified codes of the reprogrammable shadow memory and the original codes of the non-reprogrammable memory (110) to process the input data.

10. The method of claim 6, 7, 8 or 9 further comprising programming additional data into the reprogrammable shadow memory (112) of the semiconductor device, the additional data being selected from a group consisting of product identification information data and proprietary functionality data.
